Europäisches Patentamt

European Patent Office

Office européen des brevets

(11) Publication number: **0 180 183**
A2

# (12) EUROPEAN PATENT APPLICATION

(21) Application number: 85113697.8

(22) Date of filing: 28.10.85

(51) Int. Cl.⁴: **H 05 K 3/46**

(30) Priority: 29.10.84 JP 227351/84
28.12.84 JP 275965/84

(43) Date of publication of application: 07.05.86
Bulletin 86/19

(84) Designated Contracting States: DE GB IT NL

(71) Applicant: Kabushiki Kaisha Toshiba, 72, Horikawa-cho Saiwai-ku, Kawasaki-shi Kanagawa-ken 210 (JP)

(72) Inventor: Igarashi, Yutaka, 205, Hairaku Oume 2053-6, Shin-Machi, Oume-Shi Tokyo-To (JP)
Inventor: Hiraoka, Masaru, 1-506, Toshiba Kazoku Apato 2016, Shin-Machi, Oume-Shi Tokyo-To (JP)

(74) Representative: Patentanwälte Dipl.-Ing. Klaus Behn Dipl.-Phys. Robert Münzhuber, Widenmayerstrasse 6/IV, D-8000 München 22 (DE)

(54) Multilayer printed wiring board.

(57) A multilayer printed wiring board comprises at least one layer with interlayer connection pattern (200, 300) at the basic grids. The interlayer connection pattern (200, 300) has a clearance (62, 204, 304) when a small diameter through hole (60B) is formed and has a land part (63, 205, 303) contacted to the through hole wall (61A) when a large diameter through hole (60A) is formed.

In order to obtain interlayer connection or non-connection, the diameter of a through hole is varied.

## MULTILAYER PRINTED WIRING BOARD

### BACKGROUND OF THE INVENTION

The present invention relates to a multilayer printed wiring board (abbreviated PWB hereinafter) and especially to an improvement in the interlayer connection.

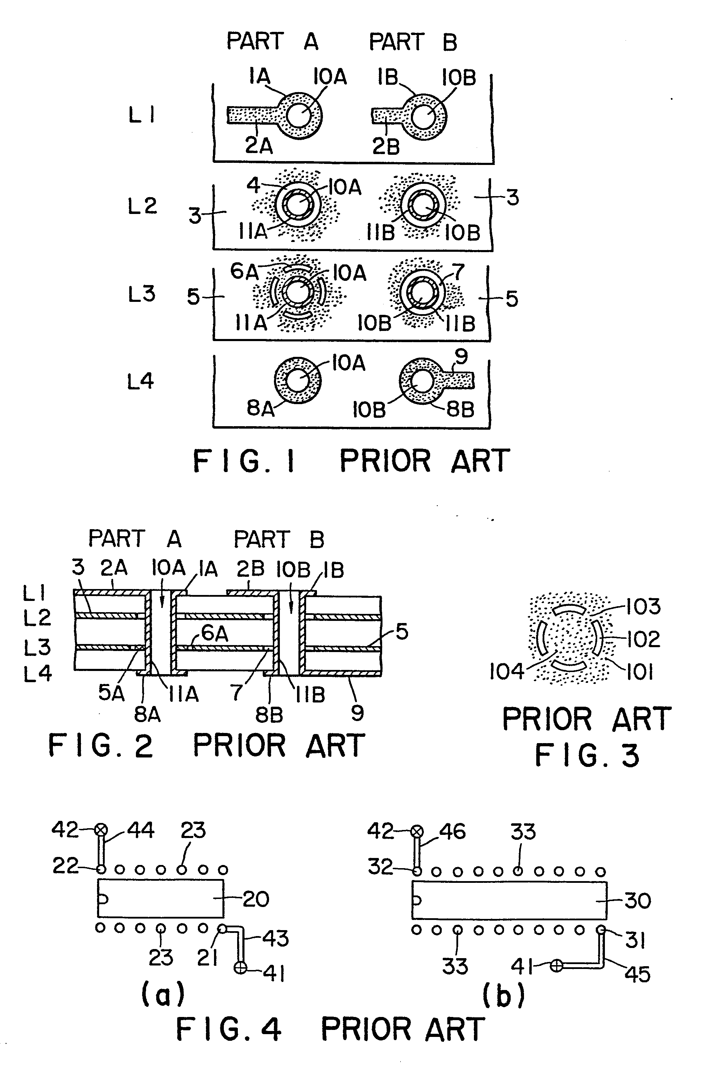

Multilayer PWBs have been widely used to increase the component mounting density as the electronic devices are highly integrated. Fig. 1 shows a composition of layers of four-layer PWB which is generally used, and Fig. 2 shows a cross sectional view of the PWB composed of above-mentioned layers along the center of a plated through hole.

In this multilayer PWB, the surface layer defines the first layer (L1), the bottom layer defines the fourth layer (L4) and two internal layers define the second (L2) and third (L3) layers, and the second layer is usually used as a ground plane, the third layer is used as a power supply plane, and the first and fourth layers are used as the signal line planes on which the circuit components are mounted and wirings are formed.

As the manufacturing cost of multilayer PWB is relatively high, it is desirable to standardize internal layer so that identical internal layers can be used for many kinds of PWBs.

The above-mentioned multilayer PWB is manufactured as follows:

The patterns of L1 to L4 are obtained by etching the copper foil on the copper clad laminates. Then prepreg sheets which are varnish impregnated thin sheets are sandwiched between the two of the layers using indexing holes to obtain correct registration and the lamination is completed by pressing with high pressure and high temperature. Next, the holes are formed by drilling in the predetermined grid positions and the holes are plated to form the plated through holes.

Fig. 1 and Fig. 2 show the structure of two plated through holes 10A and 10B. Ll plane has lands 1A and 1B around the respective through holes 10A and 10B, which have signal lines 2A and 2B respectively. L2 plane has copper foil on the whole surface except the round clearance holes (or reverse land) 4 around the through hole walls 11A and 11B. L3 plane also has clearance hole 7 around the through hole wall 11B and has copper foil around the through hole 11A. However, there is provided a functional land around the through hole wall 11A. The functional land is composed of an annular clearance hole 6A, i.e. a part which is not provided with copper foil, a land connected to the through hole wall 11A and bridging parts. This functional land prevents the heat transfer from the through hole wall to the copper foil of internal layer which has large heat capacity and improves the solderability. L4, the bottom layer, has land 8A without signal lines at through hole 10A, and has land 8B with a signal line 9 at through hole 10B. In these arrangements, L3 plane is connected to the Ll plane and L4 plane by the through hole wall 11A.

Fig. 3 is an enlarged view of the same internal layer pattern 100 as used at the through hole 10A, and it shows the condition before drilling.

Referring to Fig. 3, the functional land is composed of annular copperless reverse land 102 which has a predetermined width, a land 104 within the reverse land 102 and bridging sections formed every 90° and connecting the land 104 to the copper foil area.

However, the method in which the internal connection or non-connection is selected according to the requirement of through hole, involves the restriction on pattern design. That is, as described above, internal layers which are used as a power supply plane and a ground plane are fundamentally of the whole copper foil pattern and may well be common to every kind of printed wiring board.  However, conventional internal layer pattern must be changed according to the kind of PWB and, on the contrary, if the internal layer pattern is determined, the functions of lands on the surface layer or bottom layer are determined and unchangeable.  Consequently, outer layer pattern design is restricted and the wiring density may be decreased.

For example, the positions of through holes connected to a power supply line are determined automatically when the common inner layer is used.  Fig. 4 explains the state after the ICs are mounted to the conventional multilayer PWB.  Fig. 4(a) shows the mounting of a 14-pin IC 20 and Fig. 4(b) shows the mounting of a 20-pin IC 30.  In these figures, the ground pin 21 must be connected to the ground line, and the power supply pin 22 must be connected to the power supply line.  In this case, through hole 41 (shown by mark +) which is connected to the ground line of the multilayer PWB and the through hole 42 (shown by mark X) are formed at the position shown in Fig. 4, the ground pin 21 must be connected to the through hole 41 by the connection line 43, and the power supply pin 22 must be connected to the through hole 42 by the connection line 44.

If the 20-pin IC 30 is mounted on the same multilayer PWB, as shown in Fig. 4(b), the ground pin 31 must be connected to the through hole 41 and the power supply pin 32 must be connected to the through hole 42 using the connection lines 45 and 46.

Thus by the conventional interlayer connection, each through hole position is determined by the internal layer pattern which is commonly formed.  Consequently the degree of freedom for mounting circuit components and wiring efficiency of surface plane and bottom plane may be decreased because the complex wiring patterns must be formed according to the component mounting status.

To solve these problems, it is effective to increase the number of laminates or enlarge the size of the PWB, but these methods raise the cost of PWB.

## SUMMARY OF THE INVENTION

It is accordingly an object of this invention to provide a multilayer PWB with improved wiring density.

It is another object to provide inexpensive multilayer PWB by using a common pattern.

Briefly, this invention comprises three or more wiring layers having wiring patterns, through holes connecting an internal layer to at least one of different layers, at least one layer having interlayer connection patterns at basic grids, each of the interlayer connection patterns having a clearance when a small diameter through hole is formed, and having a land part contacted to the through hole when a large diameter through hole is formed, and the through holes being of a large diameter at the grids where interlayer connections are performed, and other through hole being of a small diameter at the grids where interlayer connections are not performed.

## BRIEF DESCRIPTION OF THE DRAWINGS

In the accompanying drawings:

Fig. 1 is a plan view of four layers of the conventional multilayer PWB, illustrating composition of lamination;

Fig. 2 is a sectional view along the center of the through hole;

Fig. 3 is an enlarged plan view of an interlayer connection pattern;

Fig. 4 is a plan view illustrating the power supply to an IC in the case of conventional multilayer PWB;

Fig. 5 is a plan view of four layers of multilayer PWB of the present invention, illustrating composition of lamination;

Fig. 6 is a sectional view along the center of the through hole shown in Fig. 5;

Figs. 7 and 8 are plan views of interlayer connection patterns which are used in the present invention;

Fig. 9 is a plan view of multilayer PWB which shows the result of application of the present invention to Fig. 4;

Fig. 10 is a sectional view of the composition of layers at a through hole for a power supply and a through hole for ground;

Fig. 11 is a plan view of four layers of the multilayer PWB of the present invention in which signal planes are inner layers; and

Fig. 12 is a cross sectional view along the center of the through hole shown in Fig. 10.

DETAILED DESCRIPTION OF THE INVENTION

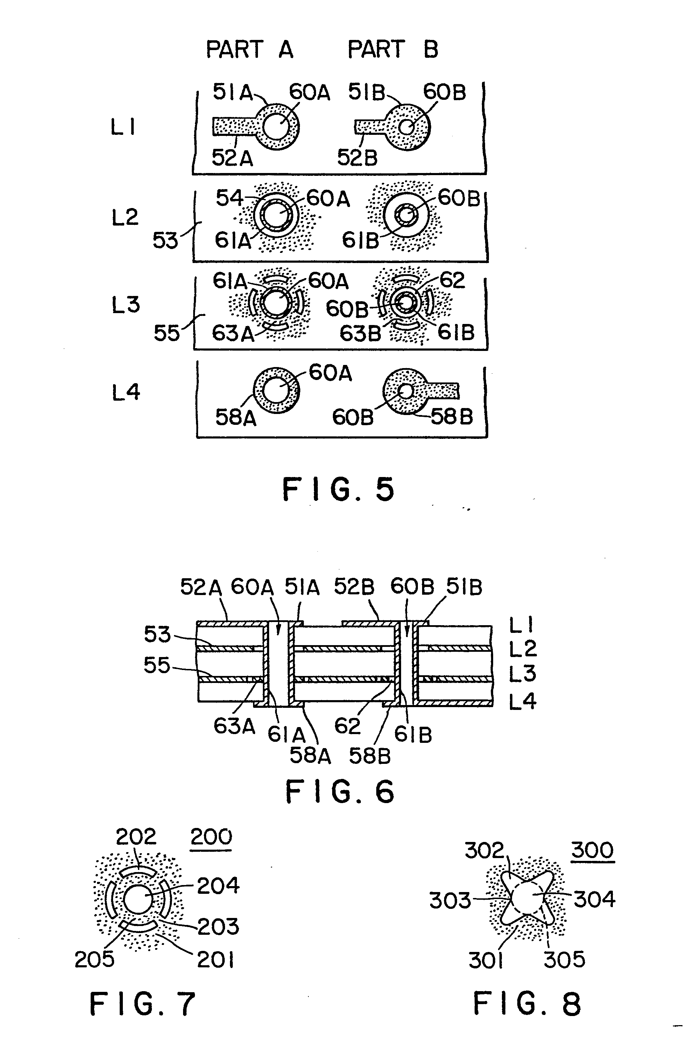

Fig. 5 illustrates the composition of layers of the present invention, and Fig. 6 illustrates the cross sectional view of the through hole along the center thereof, and these correspond to Fig. 1 and Fig. 2, respectively.

Referring to Fig. 5, the diameter of a through hole 60A at part A is larger than the diameter of a through hole 60B at part B. That is, typically the drilling of the diameter of 1 mm at part A and the drilling of the diameter of 0.5 mm at part B are performed. As a result of the two kinds of drilling, on the L3 plane having an interlayer connection pattern 200 shown in Fig. 7, the connection status at part A differs from that of part B. At part A, internal layer connection is accomplished because the diameter of the through hole 60A is larger than the diameter of the clearance hole pattern 204 which is for example 0.75 mm and the through hole wall 61A contacts the land 63. On the other hand, at part B, there is no internal connection because the diameter of the through hole 60B is smaller than the diameter of the clearance hole 62 and the through hole wall 61B exists within the clearance hole 62.

Fig. 6 clearly shows the condition of interlayer connection, that is, the wall 61A of the large diameter through hole 60A contacts the land 63A and copper foil pattern 55 and the wall 61B of the small diameter through hole 60B is apart from the land 63B connected to copper foil pattern 55 with a clearance 62. As a result of difference in through hole diameter, the widths of lands on the surface layers L1 and L4 differ according to the through hole diameter, and the clearance between the through hole and the clearance hole varies, however this variation does not affect the performance of PWB adversely.

Fig. 7 and Fig. 8 show the enlarged functional land pattern which operates as an interlayer connection at through hole part. A pattern 200 in the Fig. 7 has a circular clearance hole 204 and concentric annular clearance pattern 202 which is separated by bridge sections 203 at every approx. 90°, the bridge sections 203 connecting the copper foil around the clearnace hole 204 to the copper foil formed on whole surface around the clearance pattern 202. Clearance pattern 202 of the functional land is provided for preventing the heat diffusion from the through hole walls to the copper foil which has a large heat capacity.

A pattern 300 shown in Fig. 8 provides a clearance pattern 304 which has four projections 302 formed at approx. every 90° in the copper foil 301. A circle 305 which is formed by the root part 303 has a diameter larger than the small through hole diameter and smaller than the large through hole.

As described above, according to the present invention, connection or non-connection can be selected by varying the diameter of the through hole. Therefore a common pattern having the above through hole pattern can be used commonly for many kinds of PWBs and the pattern on the surface layer is not restricted by the inner layer pattern and can be laid out, thus improving the wiring efficiency.

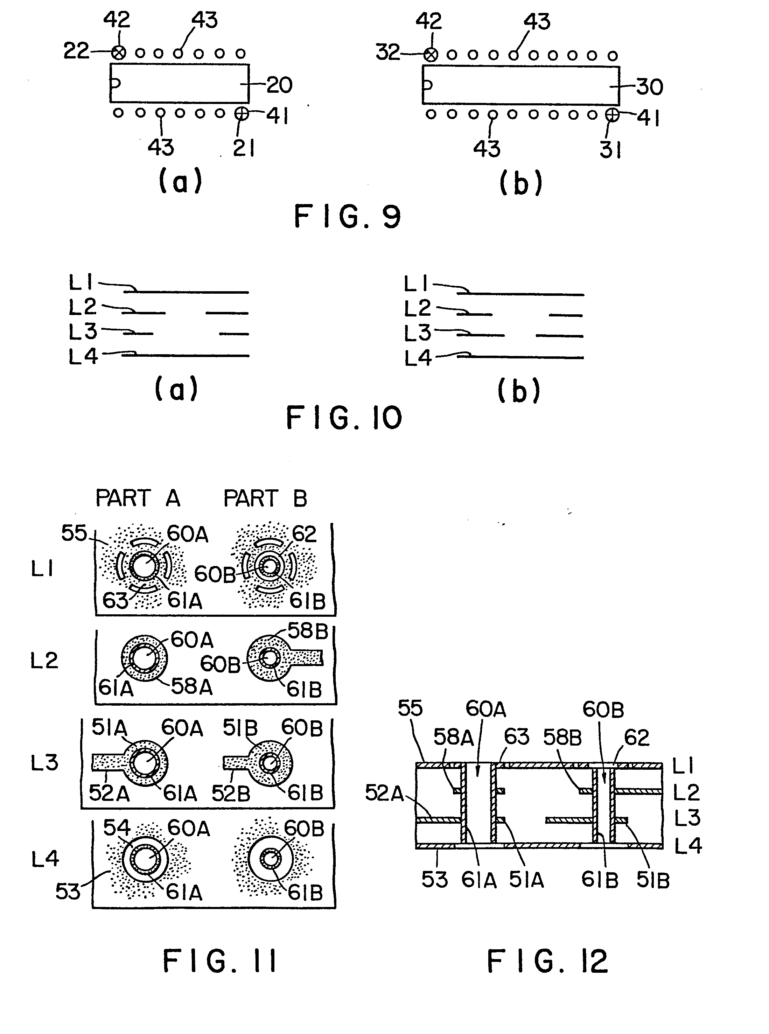

Fig. 9 shows the wiring on the surface layer of the PWB of the present invention on which a component is mounted. Fig. 9(a) illustrates the mounting of 14-pin IC 20 and Fig. 9(b) illustrates the mounting of 20-pin IC 30. Generally, as to an IC, the side where the power supply pin is arranged and the side where the ground pin is arranged are determined. Therefore if for series of through holes located upper side of IC in Fig. 9, the interlayer connection pattern 200 shown in Fig. 7 is used as L2 plane as shown in Fig. 10(a), and for series of through holes located lower side of IC in Fig. 9, the interlayer connection pattern 200 shown in Fig. 7 is used as L3 plane as shown in Fig. 10(b), efficient connection can be obtained by varying the diameter of drilling. That is, the through holes where signal pins are inserted would be small diameter through holes 43, the through hole where the ground pin 21 is inserted would be a large diameter through hole 42, and the through hole where the power supply pin 22 is inserted would be a large diameter through hole 42. If an IC having 20 pins is inserted, the large diameter through holes 41, 42 are used for the locations where ground pin 31 and the power supply pin 32 are inserted. Thus, by varying the diameters of the through holes, the optimum wiring suitable for every kind of IC can be performed.

In the above embodiment, two kinds of interlayer connection patterns are described, however they are not limitative and any pattern which has parts contacting a large diameter through hole and separating from small diameter through hole, are applicable.

These connections are also applicable to surface layers. Fig. 10 and Fig. 11 show another embodiment of this invention, and Fig. 10 shows the composition of laminates and Fig. 11 shows the cross sectional view along the center of the through holes. Referring to Fig. 10, L1 of Fig. 5 is used as L3, L2 of Fig. 5 is used as L4, L3 of Fig. 5 is used as L1 and L4 of Fig. 5 is used as L2. Such multilayer PWB is suitable for measuring instruments because of excellent anti-noise characteristics caused by the signal layers being sandwiched by copper foil layers.

As the common internal layer pattern using the above common interlayer connection pattern, an arrangement may be in the form in which the patterns shown in Fig. 7 and Fig. 8 are provided at all grid locations. Alternatively, the above common interlayer connection patterns and clearance holes patterns may be provided alternately. Especially, when this alternating pattern is used complementally, that is, at one grid, one internal layer is provided with the interlayer connection pattern and the other internal layer is provided with the clearance hole pattern, connection and non-connection can be easily selected by varying the diameter of the through hole.

Although some embodiments of the invention have been disclosed and described, it is apparent that other embodiments and modification of the invention are possible. For example, the invention is applicable to 6 layer PWB, 8 layer PWB or the like.

Therefore the scope of the invention is indicated by the appended claims and all variations which come within the meaning of the claims are intended to be embraced therein.

As described above, according to the invention, internal layers can be designed commonly to various kinds of multilayer PWBs. Outer layers can be laid out without being affected by inner layers, so that the wiring efficiency and mounting density can be raised thoroughly. Therefore high density PWB can be obtained without increasing the number of layers and the size. Furthermore, manufacturing cost can be decreased because designing manhour and manufacturing time will be decreased.

CLAIMS:

1. A multilayer printed wiring board which is composed of three or more wiring layers having wiring patterns, and through holes connecting an internal layer to at least one of different layers, characterized in that the multilayer printed wiring board comprises at least one layer having interlayer connection patterns (200, 300) at basic grids, each of said interlayer connection patterns having a clearance (62, 204, 304) when a small diameter through hole (60B) is formed, and having a land part (63, 205, 303) contacted to the through hole wall (61A) when a large diameter through hole (60A) is formed, and some of said through holes being of a large diameter at the grids where interlayer connections are performed, and other through holes being of a small diameter at the grids where interlayer connections are not performed.

2. A multilayer printed wiring board according to claim 1, wherein the inner layers have patterns being common to a plurality of kinds of PWBs.

3. A multilayer printed wiring board according to claim 1, wherein the outer layers have patterns being common to a plurality of kinds of PWBs.

4. A multilayer printed wiring board according to claim 1, wherein the clearance (204) is a circular pattern having a diameter between a large through hole (60A) diameter and a small through hole (60B) diameter.

5. A multilayer printed wiring board according to claim 1, wherein the clearance has a plurality of projections (302) and the diameter of a circule (305) formed by the root of the projections is an intermediate diameter between a large through hole (60A) diameter and a small through hole (60B) diameter.

F I G . 1  PRIOR ART

F I G . 2  PRIOR ART

PRIOR ART
F I G . 3

(a)  (b)

F I G . 4  PRIOR ART

PART A    PART B

L1

51A  60A    51B  60B
52A         52B

L2

54  60A         60B
53  61A    61B

L3

61A  60A    62
55  63A  60B  61B
63B

L4

60A
58A    60B  58B

**F I G. 5**

52A 60A 51A  52B 60B 51B

53          L1
55          L2
            L3
            L4

63A 61A  62  61B
58A 58B

**F I G. 6**

202  200
204
203
205  201

302  300
303  304
301  305

**F I G. 7**          **F I G. 8**

F I G. 9

F I G. 10

F I G. 11

F I G. 12